Europäisches Patentamt

European Patent Office

Office européen des brevets

(19)

(11) Publication number: **0 224 090 B1**

(12) **EUROPEAN PATENT SPECIFICATION**

(45) Date of publication of patent specification: **13.03.91**

(51) Int. Cl.⁵: **E05D 15/10, E06B 5/18, H05K 9/00**

(21) Application number: **86115416.9**

(22) Date of filing: **06.11.86**

(54) **Door in a structure preventing transmission of interference fields.**

(30) Priority: **21.11.85 FI 854610**

(43) Date of publication of application:
**03.06.87 Bulletin 87/23**

(45) Publication of the grant of the patent:
**13.03.91 Bulletin 91/11**

(84) Designated Contracting States:
**BE CH DE FR GB IT LI NL SE**

(56) References cited:
**EP-A- 0 095 743      EP-A- 0 096 927**
**CH-A- 616 720        DE-B- 1 264 287**
**US-A- 2 157 678      US-A- 2 893 071**
**US-A- 3 913 269**

(73) Proprietor: **EUROSHIELD OY**

**SF-27510 Eura(FI)**

(72) Inventor: **Sohlström, Lasse**

**FI-27510 Eura(FI)**

(74) Representative: **Grams, Klaus Dieter, Dipl.-Ing.
et al
Patentanwaltsbüro Tiedtke-Bühling-Kinne-
Grupe-Pellmann-Grams-Struif Winter-Roth
Bavariaring 4
W-8000 München 2(DE)**

Rank Xerox (UK) Business Services

## Description

The present invention concerns a door in a fixed structure preventing transmission of interference fields, in particular of high-frequency electromagnetic fields, according to the pre-characterizing poriton of claim 1.

The task of structures used in order to produce a space shielded against interference may be to prevent external electromagnetic energy from penetrating into the shielded space, or to confine electromagnetic energy to the space defined by the structure by preventing leakage of the field into ambience. Structures of this type are known in prior art, and they are commonly employed to shield sensitive equipment against electromagnetic radiation and to enable measurements free of radio-frequency interference to be carried out in industry, research and, far instance, hospitals applying data transfer and high frequency technology. Depending on the intended use of the shielded space, the part of the shielding presenting poorest attenuation is usually the point of contact between the openable door, window, hatch or equivalent indispensable for access to the shielded space and the fixed structure. In order to avoid effects impairing the shielding properties of the door, the electric contact between the moving part of the door and the frame, and in the case of shielding against low-frequency magnetic fields the reluctance path, should be as continuous as possible and it should be equivalent to the properties of the rest of the structure. It is possible to improve the attenuation characteristics of the joint between door and frame, above all when high frequencies are concerned, with a labyrinth structure disposed at the point of contact, wherein to the purpose of ensuring contact knife-like contact tongues on the door are pressed in between contact springs provided in a channel encircling the aperture.

However, limitations have been imposed on the performance achieved in practice with door designs of prior art by the fact that particularly the use of a multiple labyrinth structure has not been possible, owing to the requisite close fits, at the same time preserving the normal convenience in use of the door and the operating characteristics of a door. hinged in normal manner. When an efficient and complex labyrinth structure is being used, the contact tongues entering between the springs tend, owing to the close fits, to damage the seal structure by bending, under effect of the turning motion of a normally turning door, the seal springs out of alignment; and, on the other hand, closing such a door requires a very high pressing force, e.g. 300 to 400 kp.

EP-A-95 743 discloses a door in a fixed structure preventing the transmission of interference fields. The movement of this known door consists of a swinging motion about an axis defined by the hinge means and a substantially rectilinear movement producing a contact between contact elements preventing the transmission of interference fields.

In the case of certain large door designs, such a swinging motion about an axis in connection with the great weight of the door results in high requirements on the rigidity of the hinge means.

The object of the present invention is to create a simple and inexpensive door arrangement for doors of electromagnetically shielded spaces which is particularly well suited for use in connection with heavy door designs.

This object is achieved by a door arrangement comprising the features of the characterizing portion of claim 1. The movement of the door effected in a manner perpendicular with respect to the plane of the door in connection with the movement effected in the direction of the plane of the door replaces the swing motion of the door known so far. The connection between the first hinge means and the second hinge means via the guide rod belonging to the second hinge means guarantees that, before a movement perpendicular to the plane of the door to close the opening of the fixed structure is carried out, the door is always aligned in such a manner that the plane of the door is positioned exactly in parallel to the plane of the opening in the fixed structure. Thus, damage to the contact elements in a movement of the door into the opening is reliably avoided. Thus, even after a longer time of operation of the door including a frequent opening an closing of the door, the rigidity qualities of the door arrangement are not reduced.

The US-A-2 157 678 reveals a door the movement of which may take place in a direction normal or perpendicular to the plane thereof. US-A-2 157 678 relates to a refrigerator door, the movement of which being not guided and not taking place exactly rectilinearly. More particularly, in the known door arrangement, the track of the door is stationary, i.e. is rigidly secured, and not movable in the perpendicular of normal direction of the plane of the door. The door arrangement according to the US-A-2 157 678 might be suitable for a refrigerator that has a strong, so-called conical or beveled opening. However it is not at all suitable for the purpose of a door structure involving delicate, sensitive contact elements preventing transmission of interference fields which elements could be easily damaged. A precise alignment is not considered in the case of the US-A-2 157 678 since the door will ultimately be aligned when forced into the beveled opening. Furthermore, the rigidly-secured track generates a tremendous torque to the arms which also constitutes a serious drawback. The door of US-A-2 157 678 can be moved in the perpendicular direction at any time, not only when the door is properly aligned over the opening.

CH-A- 616 720 discloses the use of sliding doors in furniture. A plate is disposed to slide rectilinearly; after this sliding movement, a drawer can be drawn out perpendicularly to the preceding movement direction.

The properties, and details, of the most preferred embodiment of the invention will be apparent in greater detail from the disclosure following below and associated with the drawings that have been attached. Although therein the invention is described in connection with a door, it is understood that the invention may be equally applied in connection with a window or hatch, and in other equivalent structures, all of which are meant to be included within the scope of the invention as defined by the claims, stated farther below.

In Fig. 1 is presented a door structure according to the invention, in axonometric perspective and depicting the phase in which the door is partly open.

In Fig. 2 is presented a door structure according to the invention, likewise in axonometric perspective, and with a chain lamella structure cut open to show the chain structure.

In Fig. 3 is presented the first hinge means of the door structure of the invention, as a detail projection, and as viewed from the front.

In Fig. 4 is presented the design of Fig. 3, viewed from the side along the line IV-IV in Fig. 3.

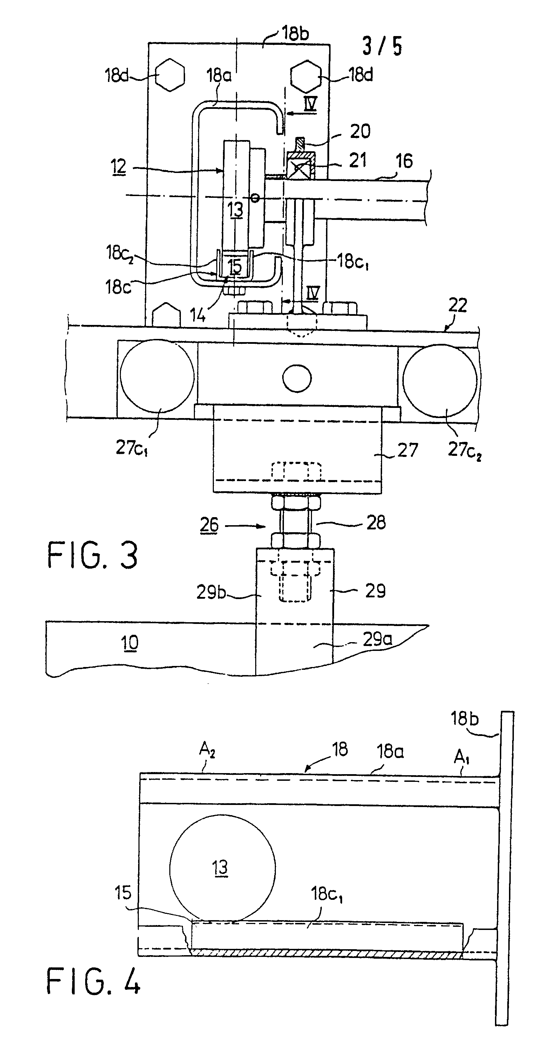

In Fig. 3 is presented the chain lamella structure, in cross section and partial projection, and in elevational view.

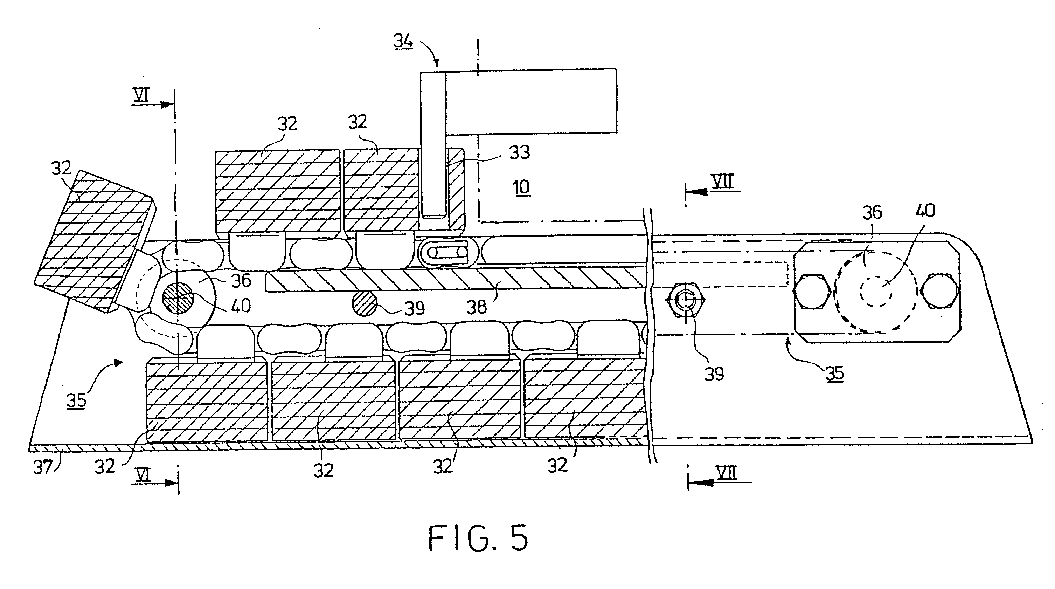

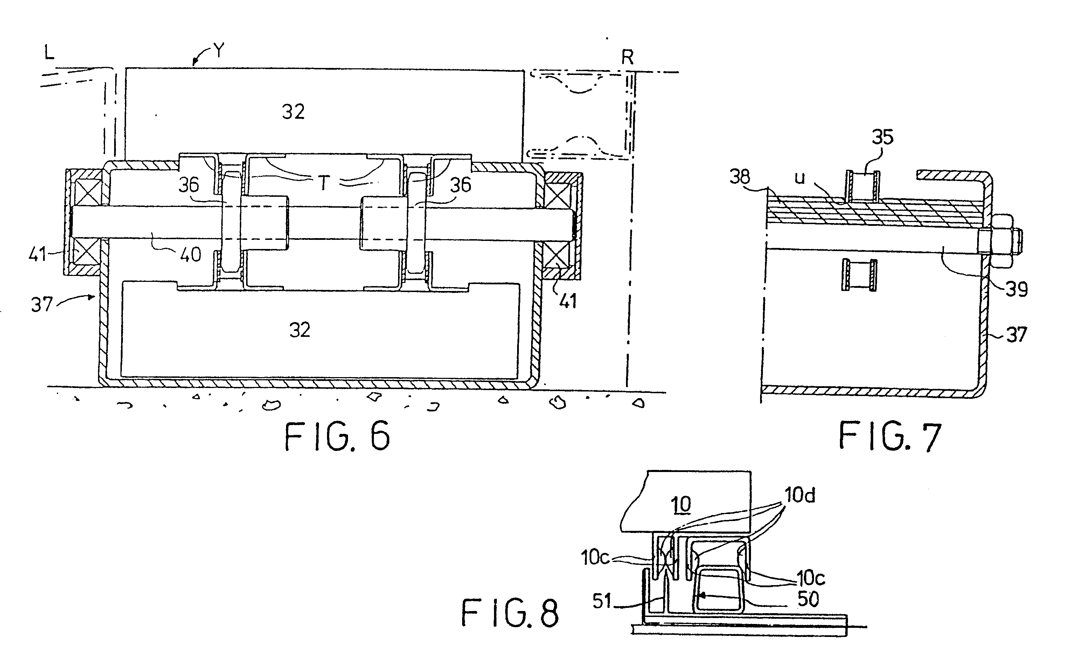

In Fig. 6 is shown the chain lamella structure, sectioned along the line VI-VI in Fig. 5.

In Fig. 7 is shown the chain lamella structure, sectioned along the line VII-VII in Fig. 5, and as partial projection.

In Fig. 8 is presented the labyrinth structure between the moving parts of the door and the fixed parts of the door structure, in horizontal section.

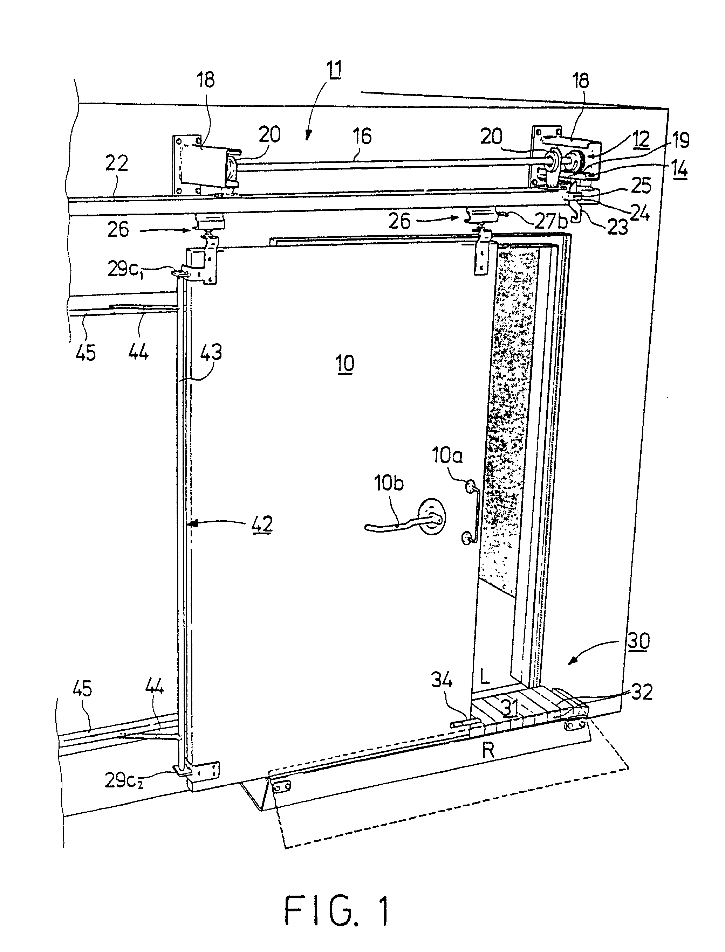

In Fig. 1, a door in general has been indicated with the reference numeral 10. The door 10 features a pull handle 10a and a locking handle 10b. The door 10 comprises first hinge means 11, comprising first and second coupling means 12 and 14, which are coupled with each other so that the door 10 can be moved substantially rectilinearly in a direction which is parallel to the normal against the door plane. In one embodiment the first coupling means 12 consist advantageously of a pinion 13 and said second hinge means 14 consist advantageously of a tooth rack 15. The pinion 13 has been disposed to move with its teeth along the tooth rack 15. In an advantageous embodiment there are two pinions 13 and they have been joined with a connecting rod 16. The pinions 13 are secured with a locking cam or equivalent, to the connecting rod 16. The tooth rack 15 has been disposed, advantageously, to be located in a beam 18. The beam 18 advantageously consists of a C section with one end open so that the pinion 13 can move into the beam 18.

The beam 18 consists of a cantilever part 18a, or its main body, and of a flange part 18b welded or otherwise fixed onto said cantilever part 18a and by which the beam 18 can be further attached to the fixed structures, e.g. to the wall structures.

On the beam 18 had further been provided a detent part 19, but it is understood that the detent part 19 may equally be placed in the vicinity of the beam 18.

The rod-like part connecting the first coupling means 12, or the pinions 13, advantageously a connecting rod 16, has been disposed to be rotatable, carried by bearing lugs 20 and bearing means 21, for instance slide or roller bearings.

There are advantageously two bearing lugs 20, and they have been disposed to be integral with a guide rod 22 or another elongated rod-like part.

On the guide rod 22 has been provided a bolt part 23 to be rotatable about a pivot pin 25. The pivot pin 25 has been pivotally connected with a fixing means 24 for the bolt part 23 and, advantageously, also with the guide rod 22.

The door structure further comprises second hinge means, or suspension means, 26, which have been functionally connected to the door 10. The suspension means 26 may advantageously comprise a suspension plate 27, adjusting means 28 and a fixing part 29. The adjusting means 28 may advantageously consist of a screw means. The said adjustment means 28 enable the door 10 to be adjusted in its height position. The suspension plate 27 has been disposed to move on the guide rod 22.

The fixing part 29 of the suspension means 26, attached to the door 10, consists advantageously of a body part 29a, a first fixing lug or equivalent 29b and a second fixing lug $29c_1$. In the embodiment here presented there are advantageously two suspension means 26, one on either upper corner of the door 10 or closely adjacent thereto. The fixing part 29 has been attached to the door 10 by screws or in another way. The second hinge means 26 comprise, advantageously, rollers $27c_1$, $27c_2$ or equivalent, supported by which the door 10 has been disposed to move along the guide rod 22.

A counterpart 27b has been disposed to cooperate with the suspension plate 27 of the suspension means 26. The counterpart 27b has been disposed to turn the bolt part 23 into such position that when the door 10 is in a position in which it covers the door opening, the door 10 can be moved with the aid of the first hinge means 11 into contact, preventing transmission of interference fields, with the fixed structures of the door 10, whereas the first coupling means 12 of the first hinge means 11 can be conveyed along the second coupling means 14 and advantageously so that the pinion 13 runs along the teeth of the tooth rack 15. When the door 10 is not in a position in which it covers the door opening, the bolt part 23 is in a position such that the door 10 cannot be moved together with its guide rod 22 in the direction of the normal against the surface plane of the door 10 towards the position $A_1$. The counterpart 27b coupled with the movement of the door has been disposed to open the bolt part 23 or equivalent when the door 10 is ready to move in support of the suspension means 26. The door 10 will then only move after the door 10 has first been moved with the aid of the first hinge means 11 from position $A_1$ into position $A_2$. The movement of the door 10 in the direction of its plane, supported by the second hinge means 26, has been disposed to take place only in position $A_2$. In this position, the detent rod 19 on the beam 18, on its underside, does not prevent the door 10 from moving in the direction of the plane of the door 10 and supported by the hinge means 26. In any other position, both position $A_1$ and positions intermediate between $A_1$ and $A_2$, the detent 19 prevents the bolt part 23 from turning and, thereby, the door 10 from moving in the direction of its surface plane, supported by the second hinge means 26. However, when the door 10 is in position $A_1$, the bolt part 23 is free to turn, pulled by the counterpart 27b and as the door 10 moves supported by the second hinge means 26.

The door structure preventing transmission of interference fields further comprises follows means 30 which follow along with the door 10. These consist, advantageously, of a chain lamella apparatus 31.

The chain lamella apparatus 31 has been disposed to consist of lamellae 32, which have been disposed to move into position in front of the threshold of the door opening when the door 10 opens.

The lamellae 32, on top in the chain lamella apparatus 31, have been arranged to lie with their top planes flush with the floor L so that, as the door 10 opens, the lamellae 32 have been disposed to lie with their top surface planes flush with the top edge of the entrance ramp R and the fixed threshold parts of the door structures and the floor L. The lamellae 32 have been disposed to be pulled in between the top edge of the entrance ramp R and the floor structures and the level of the floor L. Therefore no separate arrangements are needed for moving in separate ramps into said interspace.

The door structure preventing transmission of interference fields further comprises guiding means 42. The guiding means 42 have been disposed to support the door 10 by its edge and to guide the door 10 for moving it in the direction of the plane of the door 10, and advantageously in the direction of the wall structures, when the door 10 is being opened away from the door opening, respectively when the door 10 is being closed upon the door opening.

Said guiding means 42 comprise, advantageously, a hinge axle 43 depicted in the embodiment of Fig. 1, comprising a guide arm 44, advantageously two guide arms 44. The guide arms 44 have been disposed to be fixed to the hinge axle 43 by one nd and by their other end they have been arranged to move in longitudinal guides 45 so that the guide arms 44 with their free end move in the longitudinal axial direction of the guide 45 and also turn in relation thereto. The door 10 has been disposed to turn about the hinge axle 43 in such manner that pivoting of this turning motion has been provided at fixing lugs 29c, $29c_2$, or equivalent.

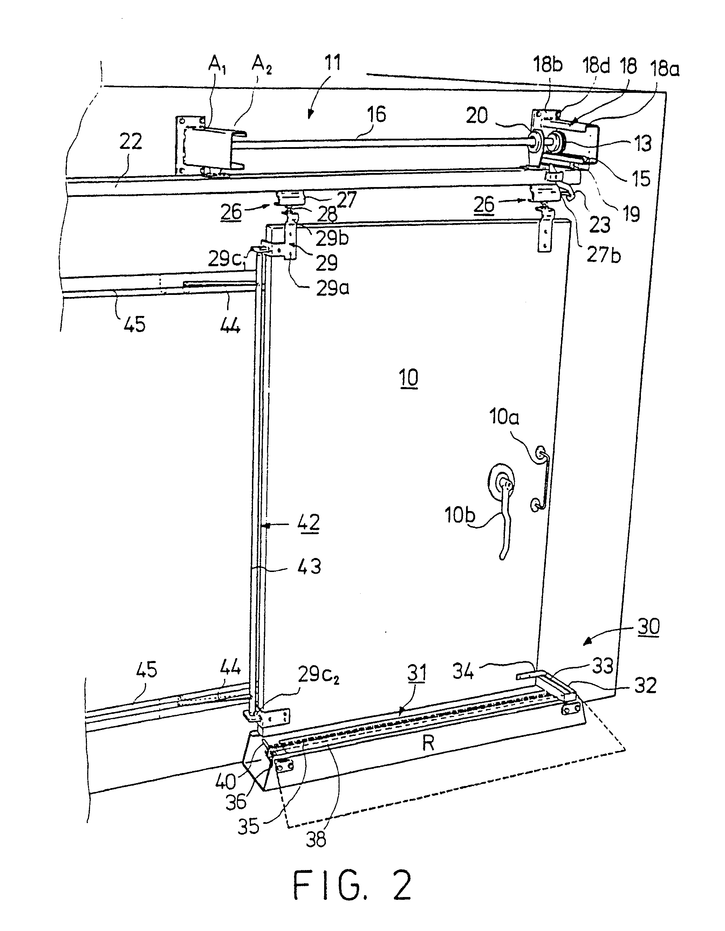

In Fig. 2 is depicted a door structure in such manner that the door 10 is in the closed position and also, in that connection, in locked position. The locking handle 10b is pressed down. In the presentation of the figure, one lamella 32 presents a lamella groove 33 which is a rectilinear groove, running parallel to the longitudinal axis of the lamella 32 substantially from end to end thereof. A guide 34 has been disposed to move in the lamella groove 33, this guide being advantageously a pin-like part which is free at one end and by its other end is attached to the door 10, substantially to the lower edge thereof. The functional purpose with the lamella groove 33 and the guide 34 is to guide the door 10 by its lower edge while the first coupling means 12, advantageously the pinion 13, and the second coupling means 14, advantageously the tooth rack 15, guide the upper edge of the door 10 as the door is moving from position $A_1$ to position $A_2$ or vice versa.

The chain lamella apparatus 31 comprises a chain 35 or equivalent. The chain 35 is disposed to move in support of wheels 36, advantageously sprocket wheels. In an advantageous embodiment there are two sprocket wheels 36 on each end of a frame beam 37 or equivalent, and there are also two chains 35. The chain 35 has been disposed to move in a guiding groove u in a supporting plate 38. The supporting plate 38 may be disposed to be movable in lateral direction, whereby the position of the chain 35 can be adjusted. Across the frame beam 37, two supporting plate-carrying axles 39 have been disposed to run. These are advantageously fitted to the frame beam 37 with screw-and-nut attachment.

The chain lamella apparatus 31 furthermore comprises a bearing shaft 40 for the sprocket wheel 36, advantageously two such bearing shafts 40 being provided and each bearing shaft 40 being disposed to rotate with its end carried by bearing means 41 in relation to the frame beam 37.

In Fig. 3 the first hinge means 11 have been shown in greater detail and in a partial projection. In Fig. 3 have more clearly been made visible the first coupling means 12, advantageously pinions 13, and the second coupling means 14, advantageously tooth racks 15. The beam 18 consists of C-section steel. The beam 18 comprises the cantilever part 18a and the flange part 18b on the end thereof. The flange part 18b has been attached to the fixed structures, advantageously with screws 18d. On the bottom of said C-section, within the section profile in the central region of its base part, has been affixed a fixing part 18c for the tooth rack 15, having U-shaped cross section. The fixing part 18c has been attached to the cantilever part 18a with the screw 18d. In the cantilever part 18a a hole has been provided for the screw 18d, this hole having such shape that the position of the fixing part 18c, and at the same time the position of the tooth rack 15, can be changed in relation to the beam 18. Hereby a possibility has been provided to adjust the tooth rack 15. The tooth rack 15 carries teeth on its top surface, fitted to mate with those of the pinion 13. Thus the tooth rack 15 and the pinion 13 are cooperative. The pinion 13 has been mounted with the locking cam or cotter pin or another equivalent securing means on the connecting rod 16. The connecting rod 16 is disposed to be rotatable, carried by the bearing means 21, advantageously roller or slide bearings, in the bearing lugs 20. In Fig. 3 is shown only one bearing lug 20 and, likewise, only one of two pinion/rack structures 13,15. The bearing lug 20 is attached by screws or equivalent means to the guide rod 22.

In Fig. 4 is presented a projection along the line IV-IV in Fig. 3. The first coupling means 12 and second coupling means 14 have been presented schematically in part. The pinion 13 has been disposed to move from position $A_2$ to the flange-side end $A_1$ of the flange on the beam 18, along the tooth rack 15. This is promoted not only by the tooth contact between the pinion 13 and the tooth rack 15 but also by the height of the walls $18c_1$ and $18c_2$ of the fixing part 18c with U-shaped cross section, which has been so selected that the walls $18c_1$ and $18c_2$ of the U section prevent excessive movements of the pinion 13 in lateral direction. When the pinion 13 is in position $A_1$, the door 10 is ready to be closed by turning the locking handle 10b.

In Fig. 5 is shown in greater detail the chain lamella apparatus 31, which comprises a plurality of lamellae 32. In one lamella 32 has been formed the elongated lamella groove 33 running longitudinally to the lamella 32 the guide 34 fitted to move in this groove 33 enabling the lower edge of the door 10 to move towards the fixed parts of the door structure for closing the door 10. The guide 34 also serves as a means moving the lamellae 32 and chains 35 when the door is being pulled in the direction parallel to its plane either into the closed or open position. The chains 35 have been disposed to run upon the supporting plate 38, and the lamellae 32 are attached to the chains 35. The chain 35 is an endless chain arranged to run over at least two sprocket wheels 36. The chain 35 and the sprocket wheels 36 have been arranged to be located within the frame beam 37 or equivalent supporting frame. The number of lamellae 32 has been chosen such that when the door 10 is in its fully open position the lamellae 32 cover a distance equal to the whole door width.

In an advantageous embodiment the supporting plate 38 is attached in relation to the frame beam 32 to be carried by the supporting axles 39. Advantageously, two supporting axles 39 are provided. They are disposed to be attachable to the frame beam 37 by screws or equivalent.

In Fig. 6 is shown the section carried along the line VI-VI in Fig. 5. On both longitudinal ends of the frame beam 37 there is a sprocket wheel-carrying or bearing shaft 40 on which the two sprocket wheels 36 have been mounted, around each being the laid chain 35. The bearing shaft 40 of the sprocket wheels 36 have been arranged with the bearing means 41 to be rotatable. Each lamella 32 has been attached to the chains 35 with a fixing member T. It is seen in Fig. 6 that when the lamellae 32 are on the upper run of the chain 35, the top surfaces of the lamellae 32 are level with the top surfaces of the floor L and the entrance ramp R of the structures on either side.

In Fig. 7 is presented a sectional view along the line VII-VII In Fig. 5, and this section is also a partial projection. In Fig. 7 is shown one of the two endless chains 35. The chain 35 has been disposed to run in the groove u on the top face of the supporting plate 38, this groove u serving as guiding groove for the chain 35. The supporting axle 39 for the supporting plate 38 is also seen in Fig. 7.

In Fig. 8 is furthermore presented a typical detail of a door structure . The door 10 and/or the fixed structure has been provided with contact elements 10d, 10c, 50, 51 which establish a contact between the door 10 and the fixed structure, preventing propagation of interference fields.

The door 10 as a rule comprises a plurality of channels 10d which have been made of sectional members of a suitable, electrically conductive material. The side walls opposite to the channels 10d have been fitted with springs 10c, made e.g. of beryllium bronze, serving as seals. When the door 10 is closed, the springs 10c receive between them the parts associated with the fixed parts of the door 10, which comprise a tongue-like contact knife 51 placed closest at the edge of the door 10 and a guide 50 with wedge-shaped cross section. The task of the springs 10c is to establish the best possible electrical contact between the contact knife 51 or the guide and the walls of the channel 10d, and also to direct the guide 50 with wedge-shaped cross section accurately into proper position when the door 10 is being closed. Owing to the close fits required for reliable contact and guiding, the pressing of the contact knife 51 and the guide 50 between the contact springs 10c, for closing the door 10, forward from the position shown in Fig. 8 is accomplished not only with the aid of the door's 10 rectilinear movement, but when the door 10 is being closed, the last part of the movement, about 2 cm, takes place as in the arrangement according to EP-A-95743, in a direction at right angles against the surface of the door 10, by turning the locking handle 10b, whereby linkage mechanisms (not depicted) move with their ends, as in the arrangement according to EP-A-95743, into the ends of bevelled guide grooves, whereby the door 10 will be pulled with high force tightly into its closed position.

## Claims

1. A door (10) in a fixed structure preventing transmission of interference fields, in particular high-frequency electromagnetic fields, said door (10) being movably disposed with respect to said fixed structure by hinge means, at least one of said door (10) and said fixed structure being provided with contact elements (10c,10d; 50,51) preventing transmission of interference fields between said door (10) and said fixed structure, characterized in that said hinge means comprise first hinge means (11) for moving said door (10) substantially rectilinearly and perpendicularly to the plane of said door (10) and second hinge means (26) for moving said door (10) substantially rectilinearly in the direction of the plane of said door (10), said second hinge means (26) comprising one single guide rod (22) mounted upon said first hinge means (11), said door (10) being mounted upon said guide rod (22) for movement in the direction of the plane of said door (10).

2. Door according to claim 1, wherein said first hinge means (11) comprise first coupling means (12) and second coupling means (14) engaged with said first coupling means (12), said coupling means (12,14) being movable relative to each other and said relative movement of said coupling means (12,14) resulting in said door (10) moving substantially rectilinearly and perpendicularly to its plane.

3. Door according to claim 2, wherein said first coupling means (12) consist of a pinion (13) and said second coupling means (14) consist of a tooth rack (15), said pinion (13) being disposed to move along the teeth of said tooth rack (15).

4. Door according to any one of claims 1 to 3, wherein said second hinge means (26) comprise support means (27,27c1,27c2, 28,29) in support of which said door (10) is movable along said guide rod (22), said support means (27,27c1,27c2,28,29) preferably comprising rollers (27c1,27c2).

5. Door according to claim 4, wherein a pinion (13) is connected to either end of a rotatable connecting rod (16), supported by bearing means (21) in at least one bearing lug (20) connected to said guide rod (22), said door (10), fitted to said second hinge means (26), being disposed to slide along said guide rod (22) in the direction of the longitudinal axis of said guide rod (22), said tooth rack (15) being fitted on a beam (18).

6. Door according to any one of claims 1 to 5, wherein said door (10) comprises follower means (30) following along with the movement of said door (10) and consisting of a chain lamella apparatus (31).

7. Door according to claim 6, wherein said chain lamella apparatus (31) comprises at least one chain (35) to which is attached a plurality of lamellae (32).

8. Door according to claim 7, wherein said lamellae (32) fitted on said chain (35) move into a position in front of the door opening when said door (10) is being opened, said door (10) being disposed to engage with said chain lamella apparatus (31) at the corner of said door's (10) lower edge and with the aid of a guide (34), said guide (34) being movable in a lamella groove (33), parallelling the longitudinal axis of said lamella (32), provided in one lamella (32).

9. Door according to claim 7 or 8, wherein said chain (35) runs over at least one sprocket wheel (36), said sprocket wheel (36) being mounted on a bearing shaft (40) carried on bearing means (41) to be rotatable in relation to a frame beam (37).

10. Door according to claims 7,8 or 9, wherein said chain (35) runs in a guiding groove (u) in a supporting plate (38) of said frame beam (37).

11. Door according to any one of claims 1 to 10, wherein a counterpart (27b) connected with the movement of said door (10) opens a bolt part (23) when said door (10) is ready to move in support of said second hinge means (26).

12. Door according to any one of claims 1 to 11, wherein guiding means (42) are arranged to guide said door (10) on its other edge.

13. Door according to claim 12, wherein said guiding means (42) comprise a hinge axle (43) turnably pivoted to fixing means, preferably fixing lugs (29c), on said door (10).

14. Door according to claim 13, wherein said hinge axle (43) comprises at least two guide arms (44) at one end pivoted to be movable and turnable in a longitudinal guide (45).

## Revendications

1. Porte (10) dans une structure fixe empêchant la transmission de champs parasites, en particulier les champs électromagnétiques haute fréquence, ladite porte (10) étant disposée de manière mobile par rapport à ladite structure fixe à l'aide de moyens d'articulation, ladite porte (10) et/ou ladite structure fixe étant pourvue(s) d'éléments de contact (10c, 10d, 50, 51) empêchant la transmission de champs parasites entre ladite porte (10) et ladite structure fixe, caractérisée en ce que lesdits moyens d'articulation comprennent des premiers moyens d'articulation (11) pour déplacer ladite porte (10) sensiblement rectilinéairement et perpendiculairement au plan de ladite porte (10) et des seconds moyens d'articulation (26) pour déplacer ladite porte (10) sensiblement rectilinéairement dans la direction du plan de ladite porte (10), lesdits seconds moyens d'articulation (26) comportant une seule barre de guidage (22) montée sur lesdits premiers moyens d'articulation (11), ladite porte (10) étant montée sur ladite barre de guidage (22) pour les mouvements dans la direction du plan de ladite porte (10).

2. Porte selon la revendication 1, dans laquelle lesdits premiers moyens d'articulation (11) comprennent un premier moyen d'accouplement (12) et un second moyen d'accouplement (14) coopérant avec ledit premier moyen d'accouplement (12), lesdits moyens d'accouplement (12, 14) étant mobiles l'un par rapport à l'autre et ledit mouvement relatif desdits moyens d'accouplement (12, 14) ayant pour résultat que ladite porte (10) effectue un mouvement sensiblement rectiligne et perpendiculaire à son plan.

3. Porte selon la revendication 2, dans laquelle ledit premier moyen d'accouplement (12) est constitué par un pignon (13) et ledit second moyen d'accouplement (14) est constitué par une crémaillère dentée (15), ledit pignon (13) étant disposé pour se déplacer le long des dents de ladite crémaillère dentée (15).

4. Porte selon l'une quelconque des revendications 1 à 3, dans laquelle lesdits seconds moyens d'articulation (26) comprennent des moyens de support (27, 27c1, 27c2, 28, 29), ladite porte (10) supportée par ceux-ci étant mobile le long de ladite barre de guidage (22), lesdits moyens de support (27, 27c1, 27c2, 28, 29) comprenant de préférence des galets (27c1, 27c2).

5. Porte selon la revendication 4, dans laquelle un pignon (13) est relié à l'une ou l'autre extrémité d'une tringle de liaison pivotante (16), supportée par des moyens formant paliers (21) dans au moins une patte (20) de support reliée à ladite barre de guidage (22), ladite porte (10), fixée auxdits seconds moyens d'articulation (26), étant disposée pour glisser le long de ladite barre de guidage (22) dans le sens de l'axe longitudinal de ladite barre de guidage (22), ladite crémaillère dentée (15) étant installée sur une poutre (18).

6. Porte selon l'une quelconques des revendications 1 à 5, dans laquelle ladite porte (10) comporte un moyen d'accompagnement (30) accompagnant le mouvement de ladite porte (10) et constitué par un dispositif (31) à chaîne et à lamelles.

7. Porte selon la revendication 6, dans laquelle ledit dispositif (31) à chaîne et lamelles comprend au moins une chaîne (35) à laquelle est fixée une pluralité de lamelles (32).

8. Porte selon la revendication 7, dans laquelle lesdites lamelles (32) installées sur ladite chaîne (35) viennent se placer face à l'ouverture de la porte au moment de l'ouverture de ladite porte (10), ladite porte (10) étant disposée pour venir au contact dudit dispositif (31) à chaîne et lamelles au niveau de l'angle du bord inférieur de ladite porte (10) et avec l'aide d'un guide (34), ledit guide (34) étant déplaçable dans une rainure (33) d'une lamelle, parallèle à l'axe longitudinal de ladite lamelle (32), réalisée dans une seule lamelle (32).

9. Porte selon la revendication 7 ou 8, dans laquelle ladite chaîne (35) passe sur au moins un pignon (36) à chaîne, ledit pignon (36) à chaîne étant monté sur un arbre de support (40) porté par un palier (41) pour pouvoir tourner par rapport à une poutrelle (37) de bâti.

10. Porte selon les revendications 7, 8 ou 9, dans laquelle ladite chaîne passe dans une gorge de guidage (u) d'une plaque de support (38) de ladite poutrelle (37) de bâti.

11. Porte selon l'une quelconque des revendications 1 à 10, dans laquelle une pièce antagoniste (27b) liée au mouvement de ladite porte (10) ouvre un loquet (23) quand ladite porte (10) est prête à effectuer un mouvement en étant supportée par lesdits seconds moyens d'articulation (26).

12. Porte selon l'une quelconques des revendications 1 à 11, dans laquelle des moyens de guidage (42) sont mis en place pour guider ladite porte (10) sur son autre bord.

13. Porte selon la revendication 12, dans laquelle lesdits moyens de guidage (42) comprennent un axe d'articulation (43) pivotant par rapport à des moyens de fixation, de préférence des pattes de fixation (29c), installés sur ladite porte (10).

14. Porte selon la revendication 13, dans laquelle ledit axe d'articulation (43) comporte au moins deux bras de guidage (44) articulés à une extrémité pour pouvoir se déplacer et pivoter dans un guide longitudinal (45).

**Ansprüche**

1. Tür (10) in einem ortsfesten Bauwerk, die eine Übertragung von Störfeldern, insbesondere hochfrequenten elektromagnetischen Feldern, verhindert, wobei diese Tür (10) mit Bezug zu dem besagten ortsfesten Bauwerk durch Gelenkeinrichtungen bewegbar angeordnet ist sowie wenigstens das eine Teil von genannter Tür (10) und besagtem ortsfesten Bauwerk mit Kontaktelementen (10c, 10d; 50, 51) versehen ist, welche die Übertragung von Störfeldern zwischen der genannten Tür und dem besagten ortsfesten Bauwerk verhindern, dadurch gekennzeichnet, daß die erwähnten Gelenkeinrichtungen erste Gelenkelemente (11) für ein Bewegen der genannten Tür (10) im wesentlichen geradlinig sowie rechtwinklig zur Ebene der genannten Tür (10) sowie zweite Gelenkelemente (26) für ein Bewegen der genannten Tür (10) geradlinig in der Richtung der Ebene der genannten Tür (10) umfassen, die besagten zweiten Gelenkelemente (26) eine einzelne, an den besaggen ersten Gelenkelementen (11) montierte Führungsstange (22) enthalten und die genannte Tür (10) auf der erwähnten Führungsstange (22) für eine Bewegung in der Richtung der Ebene der genannten Tür (10) angebracht ist.

2. Tür nach Anspruch 1, wobei die besagten ersten Gelenkelemente (11) erste Kopplungsmittel (12) sowie zweite, mit den genannten ersten Kopplungsmitteln (12) in Eingriff befindliche Kopplungsmittel (14) enthalten, die erwähnten Kopplungsmittel (12, 14) mit Bezug zueinander bewegbar sind und die besagte Relativbewegung der erwähnten Kopplungsmittel (12, 14) in einem Bewegen der genannten Tür (10) im wesentlichen geradlinig sowie rechtwinklig zu ihrer Ebene resultiert.

3. Tür nach Anspruch 2, wobei die genannten ersten Kopplungsmittel (12) aus einem Ritzel (13) und die genannten zweiten Kopplungsmittel (14) aus einer Zahnstange (15) bestehen, wobei das besagte Ritzel (13) für ein Bewegen längs der Zähne der genannten Zahnstange (15) ausgebildet ist.

4. Tür nach irgendeinem der Ansprüche 1 bis 3, wobei die besagten zweiten Gelenkelemente (26) Trageinrichtungen (27, 27c1, 27c2, 28, 29) umfassen, durch deren Unterstützung die genannte Tür (10) längs der erwähnten Führungsstange (22) bewegbar ist, wobei diese Trageinrichtungen (27, 27c1, 27c2, 28, 29) vorzugsweise Rollen (27c1, 27c2) enthalten.

5. Tür nach Anspruch 4, wobei ein Ritzel (13) mit jedem Ende einer drehbaren, durch Lagerelemente (21) in wenigstens einem mit der erwähnten Führungsstange (22) verbundenen Lagervorsprung (20) abgestützten Verbindungsstange (16) verbunden ist, die genannte, an die besagten zweiten Gelenkelemente (26) angebaute Tür (10) für ein Gleiten längs der erwähnten Führungsstange (22) in der Richtung der Längsachse dieser Führungsstange (22) angeordnet und die genannte Zahnstange (15) an einem Träger (18) angebracht ist.

6. Tür nach irgendeinem der Ansprüche 1 bis 5, wobei die genannte Tür (10) Nachführeinrichtungen (30) umfaßt, die mit der Bewegung der genannten Tür (10) mitgehen und aus einer Ketten-Lamellenvorrichtung (31) bestehen.

7. Tür nach Anspruch 6, wobei die erwähnte Ketten-Lamellenvorrichtung (31) wenigstens eine Kette (35), an der eine Mehrzahl von Lamellen (32) befestigt ist, umfaßt.

8. Tür nach Anspruch 7, wobei die genannten, an der besagten Kette (35) befestigten Lamellen (32) sich in eine Position vor der Türöffnung bewegen, wenn die genannte Tür (10) geöffnet wird, die genannte Tür (10) zum Eingriff mit der erwähnten Ketten-Lamellenvorrichtung (31) an der Ecke der unteren Kante der genannten Tür (10) sowie mit Hilfe einer Führung (34) ausgebildet ist und diese Führung (34) in einer Lamellenkehle (33), welche in einer einzelnen Lamelle (32) parallel zur Längsachse dieser Lamelle (32) vorgesehen ist, bewegbar ist.

9. Tür nach Anspruch 7 oder 8, wobei die besagte Kette (35) über wenigstens ein Kettenrad (36) läuft und dieses Kettenrad (36) an einer Lagerwelle (40) befestigt ist, die an Lagermitteln (41) drehbar mit Bezug zu einem Gestellträger (37) gelagert ist.

10. Tür nach Anspruch 7, 8 oder 9, wobei die besagte Kette (35) in einer Führungsnut (u) in einer Lagerplatte (38) des erwähnten Gestellträgers (37) läuft.

11. Tür nach irgendeinem der Ansprüche 1 bis 10, wobei ein mit der Bewegung der genannten Tür (10) gekoppeltes Gegenstück (27b) ein Riegelteil (23) öffnet, wenn die genannte Tür (10) für ein Bewegen mit Unterstützung durch die besagten zweiten Gelenkelemente (26) bereit ist.

12. Tür nach irgendeinem der Ansprüche 1 bis 11, wobei Führungseinrichtungen (42) zum Führen der genannten Tür (10) an ihrer anderen Kante angeordnet sind.

13. Tür nach Anspruch 12, wobei die besagten Führungseinrichtungen (42) eine drehbar an Befestigungsmitteln, vorzugsweise Befestigungslaschen (29c), an der genannten Tür (10) gelagerte Gelenkachse (43) umfassen.

14. Tür nach Anspruch 13, wobei die besagte Gelenkachse (43) wenigstens zwei Führungsarme (44), die am einen Ende für eine Bewegung drehbar und in einer länglichen Führung (45) verschwenkbar sind, enthält.

FIG. 1

FIG. 2

**FIG. 3**

**FIG. 4**

FIG. 5

EP 0 224 090 B1

FIG.7

FIG.6

FIG.8